(19) Europäisches Patentamt

European Patent Office

Office européen des brevets

(11) **EP 1 172 929 B1**

(12) **FASCICULE DE BREVET EUROPEEN**

(45) Date de publication et mention
de la délivrance du brevet:
**30.08.2006 Bulletin 2006/35**

(51) Int Cl.:
***H03F 3/191*** *(2006.01)*     ***H03F 3/45*** *(2006.01)*

(21) Numéro de dépôt: **01401701.6**

(22) Date de dépôt: **27.06.2001**

(54) **Dispositif d'amplification à faible bruit, en particulier pour un téléphone mobile cellulaire**

Rauscharme Verstärkungsanordnung insbesondere für ein zellulares Mobiltelefon

Low noise amplifier arrangement especially for cellular mobile telephone

(84) Etats contractants désignés:
**DE FR GB IT**

(30) Priorité: **12.07.2000 FR 0009126**

(43) Date de publication de la demande:
**16.01.2002 Bulletin 2002/03**

(73) Titulaire: **STMicroelectronics S.A.**
**92120 Montrouge (FR)**

(72) Inventeur: **Belot, Didier**
**38140 Rives (FR)**

(74) Mandataire: **Casalonga, Axel**
**Bureau Casalonga & Josse**
**Bayerstrasse 71/73**
**80335 München (DE)**

(56) Documents cités:
**DE-C- 860 506**     **DE-U- 1 783 248**
**US-A- 3 090 918**     **US-A- 3 768 020**
**US-A- 6 023 192**

**Description**

L'invention concerne les dispositifs d'amplification à faible bruit (LNA : "Low Noise Amplifier"), et plus particulièrement de tels amplificateurs utilisés dans les têtes de réception de signaux radiofréquence.

L'invention s'applique notamment aux amplificateurs à faible bruit et aux têtes de réception radiofréquence destinées aux circuits de téléphonie mobile susceptibles de fonctionner dans plusieurs bandes de fréquences distinctes.

Par exemple, pour la norme GSM, les bandes de réception sont respectivement comprises entre 925 et 960 MHz, tandis que pour la norme DCS, la bande de réception s'étend entre 1805 et 1880 MHz. Pour la norme UMTS, la fréquence centrale associée à la bande de réception est de 2200 MHz, tandis qu'elle est de 2400 MHz pour la norme "Bluetooth".

Actuellement, les dispositifs d'amplification des téléphones mobiles destinés à fonctionner selon une norme de réception prédéterminée, comportent deux étages amplificateurs montés en cascode ainsi qu'un circuit inductif/capacitif dont l'impédance est maximale pour une fréquence donnée, en l'espèce la fréquence centrale de la bande de réception. L'inductance d'un tel circuit est choisie de façon à présenter un fort coefficient de qualité, ce qui permet d'avoir une courbe gain/fréquence relativement étroite et une figure de bruit conduisant à un rapport entre le bruit en sortie et le bruit en entrée, très faible dans la bande de réception.

Actuellement, il existe un besoin de concevoir des téléphones mobiles cellulaires capables de fonctionner selon plusieurs normes de transmission, par exemple des téléphones multistandards capables de fonctionner par exemple selon toutes les normes comprises entre la norme DCS et la norme Bluetooth.

Il en résulte donc une modification nécessaire de l'étage d'amplification faible bruit situé après l'antenne de réception du téléphone.

Une première solution consiste à utiliser plusieurs amplificateurs LNA, respectivement associés aux différentes bandes fréquentielles de réception (correspondant aux différentes normes) destinées à être reçues par le téléphone mobile. Ces différents amplificateurs sont par ailleurs associés à des moyens de commande qui vont commuter le signal issu de l'antenne vers l'un des amplificateurs en fonction de la bande de réception effectivement sélectionnée par le téléphone.

Une telle solution présente à l'évidence un inconvénient majeur d'encombrement et de complexité de réalisation.

Une autre solution consiste à utiliser une charge selfique dégénérée, c'est-à-dire un élément inductif présentant un facteur de qualité plus faible. On élargit ainsi la courbe gain/fréquence, ce qui permet effectivement d'amplifier des signaux situés dans des bandes fréquentielles de réception distinctes. Cependant, le gain d'amplification d'une telle structure est plus faible, mais, et ce qui est plus gênant, la figure de bruit est dégradée, c'est-à-dire que le rapport entre le bruit en sortie et le bruit en entrée est plus important. Et, il s'avère que cette dégradation de la figure de bruit est incompatible avec certaines normes de transmission, notamment la norme UMTS.

L'invention vise à apporter une solution à ces problèmes.

Un but de l'invention est de proposer un amplificateur faible bruit large bande, c'est-à-dire qui soit capable de fonctionner dans toute une gamme de fréquences correspondant à différentes normes de transmission, et ce, en présentant à la fois un bon gain d'amplification dans toute la gamme d'utilisation de l'amplificateur, mais également un faible rapport entre le bruit en sortie et le bruit en entrée dans cette même gamme d'utilisation, c'est-à-dire quelle que soit la bande de fréquences effectivement sélectionnée dans cette gamme.

L'invention a également pour but de proposer un tel amplificateur qui soit aisément réalisable sous forme de circuit intégré et avec un encombrement non pénalisant.

L'invention propose donc un dispositif d'amplification, comportant un étage amplificateur d'entrée, un étage amplificateur de sortie monté en cascode avec l'étage amplificateur d'entrée, et un étage de charge connecté sur l'étage de sortie.

Selon une caractéristique générale de l'invention, l'étage de charge comporte plusieurs circuits élémentaires (en théorie au moins deux) comportant chacun un élément capacitif et un élément inductif présentant un coefficient de qualité supérieur à 10, et ayant respectivement des fréquences de résonance distinctes. Toutes les courbes de gain élémentaires respectivement associées à tous les circuits élémentaires présentent, à une tolérance près (par exemple environ $\pm$ 1dB), une valeur maximale de gain auxdites fréquences de résonance. Par ailleurs, les courbes de gain élémentaires respectivement associées à deux circuits élémentaires ayant respectivement deux fréquences de résonance immédiatement voisines se chevauchent en-deçà d'un seuil situé à 3dB, à une tolérance près (par exemple $\pm$ 1dB), en dessous de ladite valeur maximale de gain.

On obtient ainsi un amplificateur capable de fonctionner pour toutes les fréquences comprises entre la fréquence de résonance la plus faible de l'étage de charge et la fréquence de résonance la plus élevée de cet étage.

Et, ce type de structure fonctionne si les fréquences de résonance sont très proches les unes des autres, de façon à créer un gain "plat" sur la gamme de fréquences à couvrir.

Le caractère du gain "plat" ainsi que celui de la proximité des fréquences de résonance, est obtenu d'une part par un chevauchement des courbes de gain élémentaires à partir d'un seuil situé à 3dB en dessous de la valeur maximale de gain, et d'autre part par une même valeur maximale de gain pour chacun des circuits élémentaires inductifs-capacitifs.

On obtient par ailleurs, avec une telle structure, une configuration plate pour la figure de bruit, conduisant à une très faible valeur du rapport bruit en sortie/bruit en entrée sur toute la gamme de fréquences à couvrir.

Bien entendu, on choisira le nombre de circuits élémentaires ainsi que les fréquences de résonance de ces circuits élémentaires de façon à ce que les différentes fréquences centrales correspondant aux différentes normes destinées à être traitées par un téléphone mobile cellulaire, soient comprises entre la fréquence de résonance la plus faible et la fréquence de résonance la plus forte.

Le dispositif d'amplification selon l'invention est donc un dispositif d'amplification à large bande qui ne doit pas être confondu avec un dispositif d'amplification "multi-bandes", c'est-à-dire formé de plusieurs amplificateurs faible bruit respectivement associés à différentes fréquences centrales de réception. En outre, un tel dispositif d'amplification large bande se distingue notamment d'un dispositif d'amplification bi-bandes, voire tri-bandes ou plus généralement multi-bandes, tel que celui décrit dans la demande de brevet français n° 99 11032, qui présente un amplificateur LNA équipé d'un étage de charge comportant plusieurs circuits inductifs-capacitifs dont les fréquences de résonance doivent impérativement être très éloignées les unes des autres.

Tous les circuits élémentaires de l'étage de charge du dispositif d'amplification selon l'invention peuvent être connectés, soit en parallèle, soit en série.

Lorsque tous les circuits élémentaires sont connectés en série avec l'étage amplificateur de sortie, tous les circuits élémentaires présentent alors à leur fréquence de résonance respective une même première valeur d'impédance à une tolérance près (par exemple une tolérance de ± 20% qui correspond à la tolérance de ± 1dB évoquée ci-dessus). En outre, deux circuits élémentaires associés à deux fréquences de résonance immédiatement voisines présentent à la fréquence médiane entre leurs deux fréquences de résonance; une même deuxième valeur d'impédance égale à la moitié de ladite première valeur d'impédance, toujours à une tolérance près, par exemple à 20% près.

En d'autres termes, le caractère plat de la courbe de gain sur toute la gamme de fréquences ainsi que le recouvrement de deux bandes élémentaires de fréquences voisines se traduit en terme d'impédance par ce qui vient d'être évoqué ci-dessus pour un mode de réalisation dans lequel les circuits élémentaires sont tous connectés en série avec l'étage amplificateur de sortie.

Dans le cas où tous les circuits élémentaires seraient connectés en parallèle, ladite deuxième valeur d'impédance (c'est-à-dire celle correspondant à la fréquence médiane) devrait alors être égale au double de ladite première valeur de l'impédance, à une tolérance près. Cependant, le mode de réalisation prévoyant une connexion en série des circuits élémentaires est plus avantageux en terme d'encombrement qu'un mode de réalisation prévoyant une connexion en parallèle. En effet, pour une connexion en série, les inductances peuvent être de plus faibles valeurs, conduisant par conséquent à des encombrements plus faibles sur la pastille de silicium.

Bien qu'un dispositif d'amplification selon l'invention puisse être réalisé avec une structure à entrée unique, il est particulièrement avantageux qu'il présente une structure différentielle, ce qui permet d'obtenir une réjection de mode commun.

Ainsi, dans un mode de réalisation à structure différentielle, l'étage amplificateur d'entrée et l'étage amplificateur de sortie comportent chacun une paire de transistors. L'étage de charge comporte alors deux groupes identiques de plusieurs circuits élémentaires, les deux groupes étant respectivement connectés sur les deux transistors de l'étage amplificateur de sortie.

L'invention a également pour objet un récepteur de signaux radiofréquence, en particulier un téléphone mobile cellulaire, incorporant un dispositif d'amplification tel que celui décrit ci-avant.

D'autres avantages et caractéristiques de l'invention apparaîtront à l'examen de la description détaillée de modes de réalisation, nullement limitatifs, et des dessins annexés, sur lesquels :

- la figure 1 illustre schématiquement et partiellement certains constituants d'un téléphone mobile cellulaire selon l'invention, et notamment la tête de réception incorporant un dispositif d'amplification à faible bruit selon l'invention;
- la figure 2 illustre plus en détail mais toujours schématiquement un mode de réalisation d'un dispositif d'amplification selon l'invention, à structure différentielle; et
- les figures 3 et 4 illustrent schématiquement et respectivement une courbe en gain/fréquence et une courbe de figure de bruit, obtenues avec un dispositif d'amplification selon l'invention.

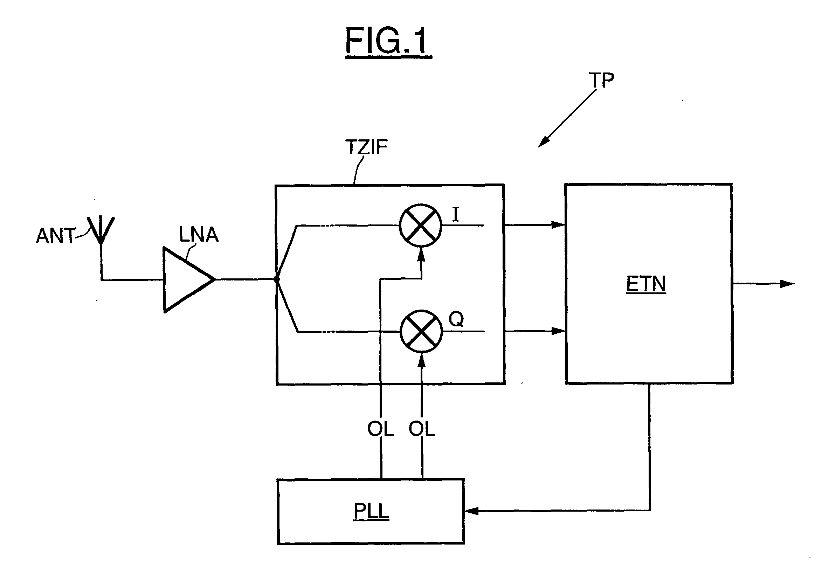

Sur la figure 1, la référence TP désigne un téléphone mobile cellulaire dont la tête de réception radiofréquence est apte à recevoir un signal radiofréquence (RF) qui provient d'une antenne de réception ANT en transitant, le cas échéant, par un coupleur d'antenne et/ou un transformateur d'isolement (non représenté).

Le signal RF est envoyé sur un amplificateur à faible bruit LNA. La sortie de l'amplificateur LNA est connectée à un synthonisateur ou tuner TZIF, de structure classique et connue en soi. Ce tuner TZIF comporte ainsi notamment sur ses deux voies de traitement des filtres passe-bande, des amplificateurs à gain commandé, et deux mélangeurs recevant respectivement de la part d'une boucle à verrouillage de phase deux signaux d'oscillateur local OL mutuellement déphasés de 90°, de façon à définir une voie de référence (en phase), à savoir la voie I, et une voie en quadrature, à savoir la voie Q.

La fréquence des signaux d'oscillateur local OL définit la fréquence nominale de la bande fréquentielle de réception sélectionnée par le téléphone portable. Le tuner TZIF est couplé, par l'intermédiaire d'un étage de conversion analogique-numérique, à un étage numérique de traitement, réalisé matériellement en partie au moyen d'une logique câblée et en partie au moyen d'un processeur de traitement du signal.

La structure et les fonctions d'un tel étage ETN sont également bien connues de l'homme du métier. Plus précisément, fonctionnellement, l'étage de traitement comporte (outre des moyens d'estimation de la réponse impulsionnelle du canal de transmission, des moyens de suppression des interférences intersymbole (égaliseur), et un bloc de décodage de canal), des moyens de modulation/démodulation capables d'effectuer la démodulation du signal reçu et la modulation du signal à émettre via une chaîne d'émission (non représentée sur la figure 1 à des fins de simplification).

Par ailleurs, comme il est classique dans les téléphones portables, des moyens de contrôle automatique de fréquence délivrent, après démodulation d'un signal pilote, un mot de commande à la boucle à verrouillage de phase PLL (par exemple à un oscillateur commandé en tension et stable en température (oscillateur VTCXO) servant de référence à la boucle PLL), de façon à contrôler la précision des signaux d'oscillateur local OL.

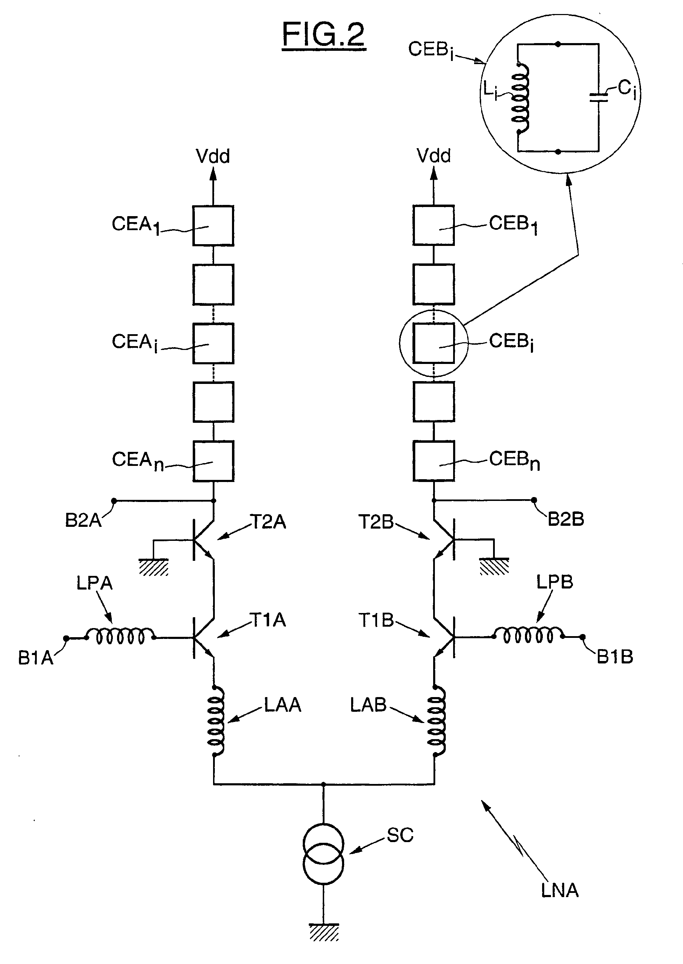

L'amplificateur à faible bruit LNA est un amplificateur large bande dont on va maintenant décrire un exemple de réalisation de structure différentielle, en se référant plus particulièrement à la figure 2.

L'amplificateur LNA, réalisé par exemple sous forme de circuit intégré, comporte essentiellement un étage amplificateur d'entrée formé d'une paire de transistors bipolaires T1A, T1B, et un étage amplificateur de sortie, monté en cascode avec l'étage d'entrée, et formé de deux autres transistors bipolaires T2A et T2B.

Plus précisément, les émetteurs des transistors T2A et T2B sont respectivement reliés aux collecteurs des transistors T1A et T1B. Les bases des transistors T2A et T2B sont reliées à la masse dynamique et les collecteurs des transistors T1A et T1B forment respectivement les deux bornes de sortie différentielle B2A et B2B de l'amplificateur.

Les bases des transistors T1A et T1B sont respectivement reliées aux deux bornes d'entrée différentielle B 1A et B 1B de l'amplificateur par deux inductances LPA et LPB.

Les émetteurs des transistors T1A et T1B sont respectivement reliés à un première borne d'une source de courant SC par l'intermédiaire de deux autres inductances LAA et LAB. L'autre borne de la source de courant SC est connectée à la masse.

Les inductances LPA et LPB d'une part et LAA et LAB d'autre part, permettent d'adapter l'impédance d'entrée de l'amplificateur. Plus précisément, les inductances LAA et LAB permettent l'adaptation avec la capacité de chaque entrée du circuit différentiel, essentiellement constituée par la capacité base-émetteur de chaque transistor T1A et T1B. Les inductances LPA et LPB permettent l'adaptation avec la capacité de base des transistors T1A et T1B. Ces inductances LPA et LPB symbolisent en fait les inductances liées au trajet des signaux d'entrée ainsi qu'aux inductances des plots de connexion et du boîtier contenant le circuit intégré.

Le recours à une structure différentielle permet d'obtenir une réjection de mode commun, tandis que les montages en cascode rendent l'impédance d'entrée indépendante des impédances de l'étage de charge ETCH connecté entre les collecteurs des transistors T2A et T2B et la tension d'alimentation Vdd.

Plus précisément, cet étage de charge ETCH est constitué de plusieurs (en théorie au moins deux) circuits élémentaires $CEA_i$ et $CEB_i$.

Tous les circuits $CEA_1$-$CEA_n$ sont connectés en série entre la tension d'alimentation Vdd et le collecteur du transistor T2A, tandis que tous les circuits élémentaires $CEB_1$-$CEB_n$ sont connectés en série entre la tension d'alimentation Vdd et le collecteur du transistor T2B.

Tous les circuits élémentaires sont structurellement identiques et formés ici, comme illustré pour le circuit $CEB_i$, d'un circuit bouchon LC comportant un élément inductif $L_i$ en parallèle avec un élément capacitif Ci.

En fait, l'impédance d'un tel circuit élémentaire n'est pas totalement réactive, mais elle comporte également une partie réelle résistive représentant, non pas à la résistance du métal constituant la self, mais la somme de toutes les pertes de l'inductance. Cette résistance parasite sera utilisée ci-après, comme on le verra plus en détail, pour le dimensionnement des éléments de chaque circuit élémentaire.

Chaque circuit élémentaire possède une fréquence de résonance distincte de la fréquence de résonance des autres circuits éléménaires, et amplifie un signal dont la fréquence se situe à l'intérieur d'une bande élémentaire de fréquences centrée autour de sa fréquence de résonance.

Cette fréquence de résonance $F_i$ est égale à

$$F_i = \omega_i/2\pi \qquad\qquad\qquad (1)$$

où

$$\omega_i = 1/\sqrt{L_i C_i} \qquad\qquad (2)$$

Par ailleurs, chaque élément inductif $L_i$ présente un coefficient de qualité supérieure à 10, par exemple un coefficient de qualité égale à 20, de façon à présenter une courbe élémentaire de gain suffisamment étroite et une figure élémentaire de bruit non dégradée.

La valeur du facteur de bruit d'un élément inductif intégré est définie par la technologie de fabrication et celui-ci est égal à

$$L_i \quad \omega_i / R_i \qquad\qquad (3)$$

où $R_i$ désigne la résistance parasite associée à l'inductance $L_i$.

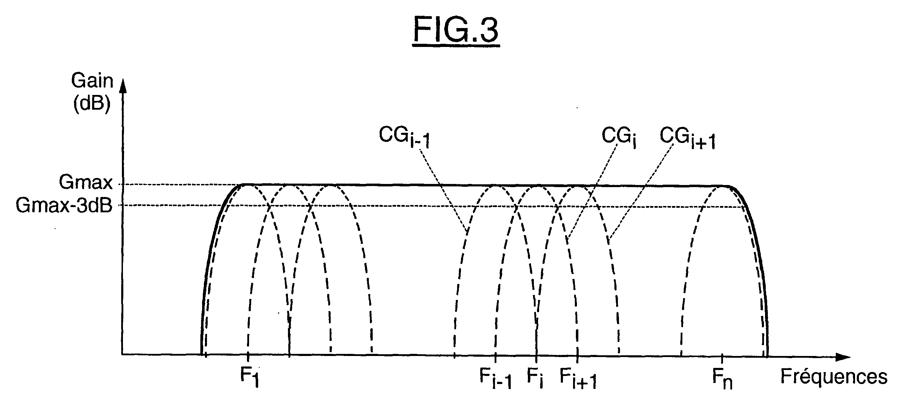

Les valeurs des inductances et des condensateurs des circuits élémentaires sont choisies de façon à ce que, comme illustré sur la figure 3, les fréquences de résonance $F_i$ soient suffisamment proches les unes des autres pour obtenir une courbe de gain sensiblement plate dans la gamme de fréquences considérée $F_1$-$F_n$.

En d'autres termes, la courbe de gain élémentaire $CG_i$ associée à un circuit élémentaire ayant une fréquence de résonance $F_i$ (c'est-à-dire la bande élémentaire de fréquences effectivement amplifiées par ce circuit élémentaire), chevauche ou recouvre la courbe de gain élémentaire $CG_{i+1}$ (respectivement $CG_{i-1}$) associée au circuit élémentaire dont la fréquence de résonance $F_{i+1}$ (respectivement $F_{i-1}$) est immédiatement voisine de la fréquence $F_i$. Ce chevauchement se situe en-deçà d'un seuil situé à 3dB (à $\pm$ 1dB près) en dessous de la valeur maximale de gain Gmax, qui est identique pour toutes les courbes élémentaires de gain $CG_i$.

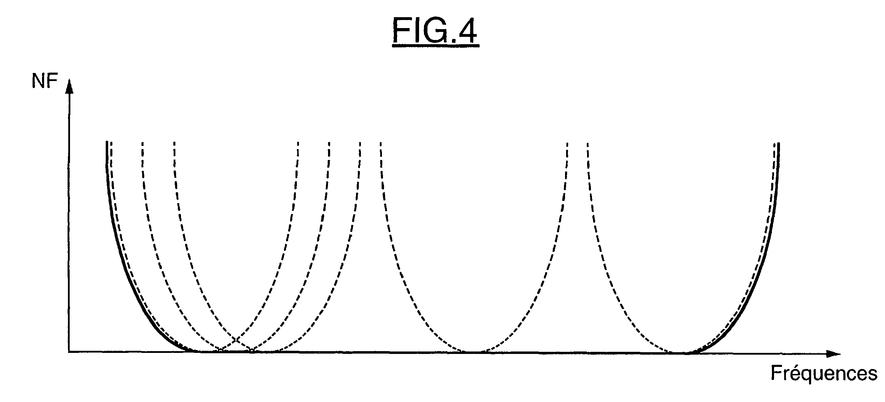

Ainsi, compte tenu du coefficient de qualité choisi pour chaque élément inductif d'un circuit élémentaire et compte tenu du caractère proche des fréquences de résonance, on obtient non seulement la courbe de gain illustrée sur la figure 3, mais également la figure de bruit NF illustrée sur la figure 4. Sur cette figure 4, les tiretés illustrent les figures de bruit élémentaires respectivement associées à chacun des circuits élémentaires et l'on remarque que la figure de bruit globale présente, pour un bruit blanc en entrée, un bruit de sortie extrêmement faible dans toute la gamme de fréquences considérée.

En terme d'impédance, le fait que toutes les courbes de gain élémentaires aient une même valeur maximale de gain Gmax et le fait que les courbes de gain élémentaires se chevauchent en-deçà d'un seuil situé à 3dB, se traduit par le fait que tous les circuits élémentaires présentent à leur fréquence de résonance respective (ou à leur pulsation de résonance $\omega_i$ respective) une première valeur d'impédance (qui est une valeur maximale) à une tolérance près (par exemple $\pm$ 20%), et
par le fait que deux circuits élémentaires associés à deux fréquences de résonance immédiatement voisines présentent à la fréquence médiane (ou à la pulsation médiane) entre leurs deux fréquences de résonance, une même deuxième valeur d'impédance égale à la moitié de ladite première valeur d'impédance, par exemple également à 20% près.

En d'autres termes, ceci se traduit par les équations (4) ci-dessous :

$$Z_i \left[ \frac{\omega_i + \omega_{i+1}}{2} \right] = Z_{i+1} \left[ \frac{\omega_i + \omega_{i+1}}{2} \right] = \frac{1}{2} Z_i (\omega_i) = \frac{1}{2} Z_{i+1} (\omega_{i+1}) \quad (4)$$

dans laquelle $Z_i$ désigne l'impédance d'un circuit élémentaire $CEA_i$ (ou $CEB_i$) et $Z_{i+1}$ l'impédance du circuit élémentaire associée à une fréquence de résonance (ou une pulsation de résonance) immédiatement voisine de celle associée au circuit $CEA_i$ (ou $CEB_i$).

$Z_i (\omega_i)$ désigne la valeur de cette impédance prise à la pulsation $\omega_i$.

La fixation des valeurs de l'inductance $L_i$ et du condensateur $C_i$ de chaque circuit élémentaire est effectuée de proche en proche à partir, par exemple, de la fréquence de résonance $F_1$ la plus faible correspondant à la borne inférieure de la bande globale de fréquences à couvrir.

On va donner à titre indicatif, un exemple de détermination de ces valeurs en utilisant deux circuits élémentaires associés à deux fréquences de résonance voisines, à savoir les fréquences $F_1$ et $F_2$ correspondant aux pulsations $\omega_1$ et $\omega_2$, et associées aux circuits $CEA_1$ (ou $CEB_1$) et $CEA_2$ (ou $CEB_2$).

L'impédance $Z_1$ du circuit $CEA_1$ prise à la pulsation $\omega$, est définie par la formule (5) ci-dessous :

$$Z_1(\omega) = \frac{R_1 + j\,L_1\,\omega}{1 - L_1\,C_1\,\omega^2 + j\,R_1\,C_1\,\omega} \qquad (5)$$

dans laquelle $j^2 = -1$.

Par ailleurs, on rappelle que les pulsations $\omega_1$, $\omega_2$ et les coefficients de qualité $Q_1$ et $Q_2$ sont respectivement définis par les formules (6, (7), (8) et (9) ci-dessous :

$$\omega_1 = 1/\sqrt{L_1 C_1} \qquad (6)$$

$$\omega_2 = 1/\sqrt{L_2 C_2} \qquad (7)$$

$$Q_1 = \frac{L_1\,\omega_1}{R_1} \qquad (8)$$

$$Q_2 = \frac{L_2\,\omega_2}{R_2} \qquad (9)$$

Il résulte de ces formules (5) et (6) que l'impédance $Z_1$ à la pulsation $\omega_1$ est définie par la formule (10) ci-dessous :

$$Z_1(\omega_1) = \frac{L_1}{R_1 C_1} - j\,\sqrt{L_1/C_1} = A_1 + j\,B_1 \qquad (10)$$

De même, l'impédance $Z_1$ à la pulsation médiane $\dfrac{\omega_1 + \omega_2}{2}$ est égale à la formule (11) ci-dessous :

$$Z_1 \left[ \frac{\omega_1 + \omega_2}{2} \right] = A + j\,B \qquad (11)$$

dans laquelle A est défini par la formule (12) :

$$A = \frac{R_1}{1 + R_1 C_1 \left[ \dfrac{\omega_1 + \omega_2}{2} \right] - L_1 C_1 \left[ \dfrac{\omega_1 + \omega_2}{2} \right]^2} \qquad (12)$$

et B est défini par la formule (13) :

$$B = \frac{L_1 \left[ \dfrac{\omega_1 + \omega_2}{2} \right]}{1 + R_1 C_1 \left[ \dfrac{\omega_1 + \omega_2}{2} \right] - L_1 C_1 \left[ \dfrac{\omega_1 + \omega_2}{2} \right]^2} \qquad (13)$$

Compte tenu des équations (4), on peut écrire en utilisant la formule (10) que A (par exemple) est également défini par la formule (14) ci-dessous :

$$A = A_1/2 = 1/2 \; \frac{L_1}{R_1 C_1} \qquad (14)$$

ce qui se traduit en utilisant la formule (12) par l'équation (15) ci-dessous :

$$-\frac{L_1 C_1}{R_1} \left[ \frac{\omega_1 + \omega_2}{2} \right]^2 + C_1 \left[ \frac{\omega_1 + \omega_2}{2} \right] + \frac{L_1 - 2\,C_1\,R_1{}^2}{L_1 R_1} = 0$$

Cette équation (15) est une équation du second degré, dans laquelle l'inconnue x est égale à $(\omega_1 + \omega_2)/2$.

On se fixe alors la valeur de la fréquence de résonance $F_1$, par exemple 2GHz, ce qui correspond à une valeur $\omega_1 = 1{,}25\ 10^{10}$ rd/s.

On se fixe également une valeur pour l'inductance $L_1$, par exemple une valeur de 2 nH, ce qui correspond, compte tenu de la technologie utilisée (technologie BiCMOS SiGe avec des éléments inductifs en aluminium de 2.5 microns d'épaisseur, un substrat de 15 Ohm.cm et des oxydes inter-métal formés de $SiO_2$), à un coefficient de qualité $Q_1$ = 20.

On peut donc en déduire, compte tenu de la formule (8), la valeur de la résistance $R_1$ qui est en l'espèce égale à 1,25 Ohm.

On en déduit alors à partir de la formule (6), la valeur capacitive du condensateur $C_1$ qui est en l'espèce égale à 3,2 pF.

La résolution de l'équation (15) donne pour la variable x la valeur de $12,7^{10}$, ce qui fournit pour $\omega_2$ la valeur de $12,9 \cdot 10^9$ rd/s, soit une fréquence $F_2$ = 2,05 GHz.

On fixe alors à nouveau la valeur de l'inductance $L_2$, par exemple à 2 nH, ce qui correspond encore à un coefficient de qualité $Q_2$ = 20. On obtient une valeur $R_2$ = 1,25 Ohm à partir de la formule (9), et une valeur capacitive pour le condensateur $C_2$ = 3,1 pF à partir de la formule (7).

On peut ensuite déterminer la fréquence $F_3$, voisine de la fréquence $F_2$, en effectuant les mêmes opérations que celles décrites précédemment et en remplaçant $\omega_1$ par $\omega_2$ et $\omega_2$ par $\omega_3$.

On procède ensuite de proche en proche jusqu'à la détermination de la fréquence $F_n$ et par conséquent la détermination des valeurs $L_n$ et $C_n$.

On obtient donc un pas de 50 MHz par circuit élémentaire.

Ainsi, à titre indicatif, pour un téléphone portable capable de couvrir toutes les normes comprises entre la norme DCS et la norme Bluetooth, il sera nécessaire de prévoir une douzaine de circuits élémentaires $CEA_i$ (et une douzaine de circuits $CEB_i$).

Bien entendu, il aurait été possible de fixer, dans chacun des calculs élémentaires décrits ci-dessus, la valeur du condensateur pour en déduire la valeur de l'inductance. Néanmoins, il était préférable de fixer la valeur de l'inductance pour en déduire la valeur capacitive du condensateur, car la fixation de l'inductance permet aisément de choisir un coefficient de qualité élevé.

L'homme du métier aura par conséquent noté que dans ce mode de réalisation, tous les éléments inductifs $L_i$ sont identiques, chaque circuit élémentaire $CEA_i$ ou $CEB_i$ différant des autres par la valeur de l'élément capacitif.

Matériellement, il n'est pas nécessaire que deux circuits élémentaires associés à deux fréquences de résonance immédiatement voisines soient disposés côte à côte sur le silicium.

## Revendications

1. Dispositif d'amplification, comportant un étage amplificateur d'entrée (T1A, T1B), un étage amplificateur de sortie (T2A, T2B) monté en cascode avec l'étage amplificateur d'entrée, et un étage de charge connecté sur l'étage de sortie, **caractérisé par le fait que** l'étage de charge comporte plusieurs circuits élémentaires ($CEA_i$, $CEB_i$) comportant chacun un élément capacitif ($C_i$) et un élément inductif ($L_i$) présentant un coefficient de qualité supérieur à 10, et ayant respectivement des fréquences de résonance distinctes ($F_i$), **par le fait que** toutes les courbes de gain élémentaires ($CG_i$) respectivement associées à tous les circuits élémentaires présentent, à une tolérance près, une même valeur maximale de gain (Gmax) auxdites fréquences de résonance, et **par le fait que** les courbes de gain élémentaires respectivement associées à deux circuits élémentaires ayant respectivement deux fréquences de résonance immédiatement voisines se chevauchent en-deçà d'un seuil situé à 3dB, à une tolérance près, en dessous de ladite valeur maximale de gain.

2. Dispositif selon la revendication 1, **caractérisé par le fait que** la valeur absolue de ladite tolérance est d'environ 1 dB.

3. Dispositif selon la revendication 1, **caractérisé par le fait que** tous les circuits élémentaires ($CEA_i$, $CEB_i$) sont connectés en série avec l'étage amplificateur de sortie, **par le fait que** tous les circuits élémentaires présentent à leur fréquence de résonance respective ($F_i$) une même première valeur d'impédance à une tolérance près, **par le fait que** deux circuits élémentaires associés à deux fréquences de résonance immédiatement voisines présentent à la fréquence médiane entre leurs deux fréquences de résonance une même deuxième valeur d'impédance égale à la moitié de ladite première valeur d'impédance, à une tolérance près.

4. Dispositif selon la revendication 3, **caractérisé par le fait que** ladite tolérance est égale à 20%.

5. Dispositif selon l'une des revendications précédentes, **caractérisé par le fait que** chaque circuit élémentaire comporte un élément inductif ($L_i$) et un élément capacitif ($C_i$) connectés en parallèle, et **par le fait que** tous les éléments inductifs de tous les circuits élémentaires sont identiques.

6. Dispositif selon l'une des revendications précédentes, **caractérisé par le fait qu'**il présente une structure différentielle, l'étage amplificateur d'entrée et l'étage amplificateur de sortie comportant chacun une paire de transistors, et **par le fait que** l'étage de charge (ETCH) comporte deux groupes identiques de plusieurs circuits élémentaires (CEA$_i$, CEB$_i$), les deux groupes étant respectivement connectés sur les deux transistors de l'étage amplificateur de sortie.

**7.** Récepteur de signaux radiofréquence, en particulier téléphone mobile cellulaire, **caractérisé par le fait qu'**il comprend un dispositif d'amplification tel que défini dans l'une des revendications précédentes.

## Claims

**1.** Amplifier including an input amplifier stage (T1A, T1B), an output amplifier stage (T2A, T2B) cascode-connected with the input amplifier stage, and a load stage connected to the output stage, **characterized in that** the load stage includes a plurality of circuits (CEA$_i$, CEB$_i$) each including a capacitive component (C$_i$) and an inductive component (L$_i$) having a Q greater than 10 and having respective different resonant frequencies (F$_i$), **in that** all the gain curves (CG$_i$) respectively associated with all the circuits have, to within a stated tolerance, the same maximum gain value (Gmax) at said resonant frequencies, and **in that** the gain curves respectively associated with two circuits having respective immediately adjacent resonant frequencies overlap below a threshold at 3 dB, to within a stated tolerance, below said maximum gain value.

**2.** Amplifier according to Claim 1, **characterized in that** the absolute value of said tolerance is approximately 1 dB.

**3.** Amplifier according to Claim 1, **characterized in that** all the circuits (CEA$_i$, CEB$_i$) are connected in series with the output amplifier stage, **in that** all the circuits have at their respective resonant frequency (F$_i$) the same first impedance value, to within a stated tolerance, and **in that** two circuits associated with two immediately adjacent resonant frequencies have at the median frequency between their two resonant frequencies the same second impedance value equal to half said first impedance value, to within a stated tolerance.

**4.** Amplifier according to Claim 3, **characterized in that** said tolerance is equal to 20%.

**5.** Amplifier according to any preceding claim, **characterized in that** each circuit includes an inductive component (L$_i$) and a capacitive component (C$_i$) connected in parallel and **in that** all the inductive components of all the circuits are identical.

**6.** Amplifier according to any preceding claim, **characterized in that** it has a differential structure and the input amplifier stage and the output amplifier stage each include a pair of transistors and **in that** the load stage (ETCH) includes two identical groups of circuits (CEA$_i$, CEB$_i$) connected to the respective transistors of the output amplifier stage.

**7.** Radio-frequency signal receiver, in particular a cellular mobile telephone, **characterized in that** it includes an amplifier as defined in any preceding claim.

## Patentansprüche

**1.** Verstärkungsvorrichtung, umfassend eine Eingangsverstärkungsstufe (T1A, T1B), eine Ausgangsverstärkungsstufe (T2A, T2B), die in Kaskade mit der Eingangsverstärkungsstufe vorgesehen ist, und eine Ladestufe, die an die Ausgangsstufe angeschlossen ist, **dadurch gekennzeichnet, dass** die Ladestufe mehrere Elementarschaltungen (CEA$_i$, CEB$_i$) umfasst, umfassend jeweils ein kapazitives Element (C$_i$) und ein induktives Element (L$_i$), die einen Qualitätskoeffizienten über 10 aufweisen, jeweils umfassend unterschiedliche Resonanzfrequenzen (F$_i$) auf Grund der Tatsache, dass alle elementaren Verstärkungskurven (CG$_i$), die jeweils mit allen Elementarschaltungen verbunden sind, mit einer gewissen Toleranz einen selben maximalen Verstärkungswert (Gmax) bei den Resonanzfrequenzen aufweisen, und auf Grund der Tatsache, dass die elementaren Verstärkungskurven, die jeweils mit zwei Elementarschaltungen verbunden sind, jeweils zwei unmittelbar benachbarte Resonanzfrequenzen aufweisen, die einander über eine Schwelle von 3 dB hinaus mit einer gewissen Toleranz unter dem maximalen Verstärkungswert überlagern.

**2.** Vorrichtung nach Anspruch 1, **dadurch gekennzeichnet, dass** der Absolutwert der Toleranz ungefähr 1 dB beträgt.

**3.** Vorrichtung nach Anspruch 1, **dadurch gekennzeichnet, dass** alle Elementarschaltungen ($CEA_i$ $CEB_i$) in Serie an die Ausgangsverstärkungsstufe angeschlossen sind, dass alle Elementarschaltungen bei ihrer jeweiligen Resonanzfrequenz ($F_i$) einen ersten Impedanzwert mit einer gewissen Toleranz aufweisen, dass zwei mit zwei unmittelbar benachbarten Resonanzfrequenzen verbundene Elementarschaltungen bei der Mittelfrequenz zwischen ihren beiden Resonanzfrequenzen mit einer gewissen Toleranz einen selben zweiten Impedanzwert gleich der Hälfte des ersten Impedanzwerts aufweisen.

**4.** Vorrichtung nach Anspruch 3, **dadurch gekennzeichnet, dass** die Toleranz gleich 20 % ist.

**5.** Vorrichtung nach einem der vorhergehenden Ansprüche, **dadurch gekennzeichnet, dass** jede Elementarschaltung ein induktives Element ($L_i$) und ein kapazitives Element ($C_i$), die parallel geschaltet sind, aufweist, und dass alle induktiven Elemente aller Elementarschaltungen identisch sind.

**6.** Vorrichtung nach einem der vorhergehenden Ansprüche, **dadurch gekennzeichnet, dass** sie eine Differentialstruktur aufweist, wobei die Eingangsverstärkungsstufe und die Ausgangsverstärkungsstufe jeweils ein Transistorpaar aufweisen, und dass die Ladestufe (ETCH) zwei identische Gruppen von mehreren Elementarschaltungen ($CEA_i$ $CEB_i$) umfasst, wobei die beiden Gruppen jeweils an die beiden Transistoren der Ausgangsverstärkungsstufe angeschlossen sind.

**7.** Empfänger für Funkfrequenzsignale, insbesondere ein Zellmobiltelefon, **dadurch gekennzeichnet, dass** er eine Verstärkungsvorrichtung, wie in einem der vorhergehenden Ansprüche definiert, umfasst.

# FIG.1

EP 1 172 929 B1

# FIG.2

## FIG.3

# FIG.4

NF

Fréquences